# EUROPEAN PATENT APPLICATION

(11) **EP 4 503 580 A1**
(43) Date of publication of application: **05.02.2025**
(21) Application number: 23826166.3
(22) Date of filing: 08.06.2023
(51) Int. Cl.: H04L 67/131

(54) **CONSTRUCTION METHOD, FIRST COMMUNICATION NODE, STORAGE MEDIUM AND CONSTRUCTION SYSTEM**

(30) Priority: 20.06.2022 CN 202210701470
(71) Applicant: ZTE Corporation, Shenzhen, Guangdong 518057 (CN)
(72) Inventor: LIAO, Jinlong, Shenzhen, Guangdong 518057 (CN); WANG, Bo, Shenzhen, Guangdong 518057 (CN); LV, Xingzai, Shenzhen, Guangdong 518057 (CN)
(74) Representative: Aipex B.V.
(86) International application number: PCT/CN2023/099084
(87) International publication number: WO 2023/246517

(57) **Abstract**

Provided are a construction method, a first communication node, a storage medium and a construction system. The method includes: acquiring, from a model library, a model required for constructing a digital twin of a communication system, where the model is generated based on target data of the communication system, and models for constructing multiple communication systems are stored in the model library; and constructing the digital twin based on the model.

## Description

### TECHNICAL FIELD

The present application relates to the technical field of communication, for example, a construction method, a first communication node, a storage medium and a construction system.

### BACKGROUND

A digital twin is a conceptual system of interaction between a physical world and a digital space. Construction of a digital twin of a communication system facilitates analysis, simulation and control optimization of an entire lifecycle of a physical entity network of the communication system, facilitating intelligent operation of the physical entity network.

At present, a communication node for constructing a digital twin of a communication system can only be dedicated to construction of a digital twin of a certain communication system or a certain generation of communication system, and the versatility of the communication node is poor.

### SUMMARY

The present application provides a construction method, a first communication node, a storage medium and a construction system.

An embodiment of the present application provides a construction method. The construction method is applied to a first communication node and includes the following.

A model required for constructing a digital twin of a communication system is acquired from a model library, where the model is generated based on target data of the communication system, and models for constructing a plurality of communication systems are stored in the model library.

The digital twin is constructed based on the model.

An embodiment of the present application further provides a first communication node. The first communication node includes one or more processors; and a storage apparatus in which one or more program are stored.

The one or more programs, when executed by the one or more processors, cause the one or more processors to perform the preceding construction method.

An embodiment of the present application further provides a storage medium storing a computer program which, when executed by a processor, causes the processor to perform the preceding construction method.

An embodiment of the present application further provides a construction system. The system includes the first communication node provided in the embodiment of the present application, a second communication node and a communication system, where a digital twin of the communication system is included in the second communication node.

The preceding embodiments and other aspects of the present application and implementations thereof are described in more detail in the brief description of drawings, detailed description and claims.

### BRIEF DESCRIPTION OF DRAWINGS

FIG. 1 is a flowchart of a construction method according to an embodiment.
FIG. 2 is a diagram illustrating the implementation of a construction method for a digital twin of a communication system according to an embodiment.
FIG. 3 is a diagram illustrating the implementation of a construction apparatus for a digital twin of a communication system according to an embodiment.
FIG. 4 is another diagram illustrating the implementation of a construction method for a digital twin of a communication system according to an embodiment.
FIG. 5 is a diagram illustrating the structure of a construction apparatus according to an embodiment.
FIG. 6 is a diagram illustrating the hardware structure of a first communication node according to an embodiment.
FIG. 7 is a diagram illustrating the structure of a construction system according to an embodiment.

### DETAILED DESCRIPTION

To make the objects, technical solutions and advantages of the present application more apparent, embodiments of the present application are described hereinafter in detail in conjunction with the drawings. It is to be noted that if not in collision, the embodiments of the present application and features therein may be combined with each other in any manner.

The steps illustrated in the flowcharts among the drawings may be performed by, for example, a computer system capable of executing a set of computer-executable instructions. Moreover, though logical sequences are illustrated in the flowcharts, the steps illustrated or described may be performed in sequences different from those described herein in some cases.

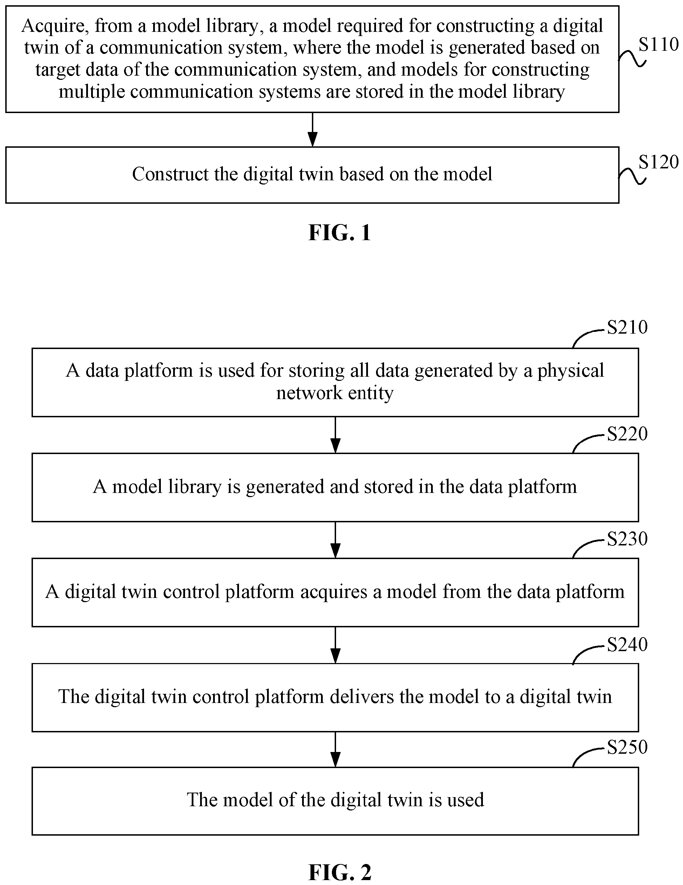

FIG. 1 is a flowchart of a construction method according to an embodiment. As shown in FIG. 1, the method provided in this embodiment may be applied to a first communication node. The construction method includes S110 and S120.

In S110, a model required for constructing a digital twin of a communication system is acquired from a model library, where the model is generated based on target data of the communication system, and models for constructing multiple communication systems are stored in the model library.

In this embodiment, the digital twin may be construed as a digital mapping system that makes full use of data such as a physical model, sensor updating and an operation history, integrates a multi-disciplinary, multi-physical, multi-scale and multi-probability simulation process and completes mapping in a virtual space to reflect an entire lifecycle process of a corresponding physical equipment. Through the construction of the digital twin of the communication system, analysis, simulation and control optimization of an entire lifecycle can be performed on the physical entity network of the communication system, facilitating the intelligent operation of the physical entity network.

The models for constructing the multiple communication systems are stored in the model library. These models may be generated based on the target data of the communication system.

The multiple communication systems may include, but are not limited to, a communication system based on Long-Term Evolution (LTE) in the fourth-generation mobile communication technology (4G), a communication system based on New Radio (NR) of the fifth-generation mobile communication technology (5G) and a wireless communication system based on the sixth-generation mobile communication technology (6G).

The target data may be construed as data associated with the construction of the digital twin of the physical entity network of the communication system. The target data is not specifically limited herein. For example, before the digital twin is constructed and operated, the target data may include data of the communication system (such as all data of the communication system or part of data determined according to an actual requirement), for example, operation data of the communication system (such as a physical network entity), an operation state of the communication system, a network element feature attribute of the communication system, engineering parameter information of the communication system, environmental information (such as a wireless environment) of the communication system, configuration parameter data of the communication system and/or model data required for constructing the digital twin of the communication system. After the digital twin is constructed and operated, the target data may further include data generated by constructing the digital twin and/or data generated by the digital twin (such as data representing an operation condition of the digital twin). Based on this, the model may be generated based on the target data of the communication system. How to generate the model based on the target data of the communication system is not specifically limited herein.

In this embodiment, the model library may be stored in a digital twin control platform, may also be stored in a data platform in a digital twin control platform, or may also be stored in a data warehouse in a digital twin control platform. This is not specifically limited herein. Based on this, the model required for constructing the digital twin of the communication system may be acquired from the model library through the digital twin control platform, for example, from the model library in the digital twin control platform, from the model library in the data platform in the digital twin control platform, or from the model library in the data warehouse in the digital twin control platform.

The model library may include one or more models, for example, including, but not limited to, a data type model, a simulation type model, an intelligence type model and a protocol stack model. The data type model may be construed as a model that includes a historical network data attribute set representing the communication system and a current network data attribute set representing the communication system. The simulation type model may be construed as a model that simulates a physical process of a network of the communication system and a function of the network of the communication system. The intelligence type model may be construed as a model constructed based on artificial intelligence (AI) technology for the input and output of data. The protocol stack model may be construed as a model of the protocol stack architecture of the communication system, and the protocol stack architecture is obtained according to a communication standard.

Digital twins of different communication systems may have different models required for corresponding construction. For example, the models may include the data type model, the simulation type model, the intelligence type model and/or the protocol stack model. The models for constructing the multiple communication systems stored in the model library may be stored separately or may also be stored in classifications (or in partitions). For example, for each communication system, models required for constructing a corresponding digital twin may be classified as one type for storage. This is not specifically limited herein.

Based on this, in the process of acquiring, from the model library, the model required for constructing the digital twin of the communication system, which models are acquired and the sequence of obtaining these models are determined according to an actual requirement. For example, the protocol stack model may be first acquired, the simulation type model and the intelligence type model are then acquired and applied to the protocol stack model, and the data type model is finally acquired. It is to be noted that since the protocol stack model is the basis, the protocol stack model is required to be acquired first, and a corresponding acquisition sequence of other models may be determined according to an actual requirement.

In S120, the digital twin is constructed based on the model.

In this embodiment, the digital twin may be mounted on the first communication node, that is, the digital twin and the digital twin control platform belong to the same carrier (that is, the first communication node). Alternatively, the digital twin may also be mounted on a second communication node. This is not limited herein.

Based on this, if the digital twin and the digital twin control platform belong to the same carrier (that is, the first communication node), the first communication node may construct the digital twin locally. If the digital twin is mounted on the second communication node, the first communication node may transmit the acquired model to the second communication node including the digital twin, and the second communication node constructs the digital twin based on the received model. How to construct the digital twin based on the model is not specifically limited herein.

In the process of transmitting the model to the second communication node, the transmission sequence of models may be determined according to an actual requirement. For example, the protocol stack model may be transmitted first, and the simulation type model, the intelligence type model and the data type model may be then transmitted.

In this embodiment, the models for constructing the multiple communication systems are stored in the model library, the model required for constructing the digital twin of the communication system is acquired from the model library according to the actual requirement, and the digital twin is then constructed based on the model. Since the model library stores the models of the multiple communication systems, digital twins can be constructed for the multiple communication systems respectively so that the problem that a communication node for constructing a digital twin of a communication system can only be dedicated to the construction of a digital twin of a certain communication system or a certain generation of communication system can be solved, improving the universality of the communication node.

In an embodiment, the construction method further includes the following.

The model library is generated based on the target data of the communication system.

In this embodiment, before the model required for constructing the digital twin of the communication system is acquired from the model library, multiple models may also be generated correspondingly based on the target data of the communication system. The multiple models may form one model library. How to generate the model library based on the target data of the communication system is not specifically limited herein. For example, after classification, the target data may be configured to generate the models. A specific classification manner is not limited. For example, the target data is classified according to the types of the models included in the model library. After the classification, the target data may be configured to form the models. The models may be each a data set or may also be each a neural network model.

In an embodiment, the construction method further includes the following.

The target data of the communication system is acquired.

The target data is stored.

In this embodiment, before the model library is generated, the target data of the communication system required for generating the model library may be acquired. After the target data of the communication system is acquired, the target data may be stored in the digital twin control platform such as the data platform in the digital twin control platform or the data warehouse in the digital twin control platform. A storage manner for the target data is not specifically limited herein.

In an embodiment, the target data includes the data of the communication system.

In this embodiment, the data of the communication system may refer to all or part of data associated with the communication system and may include, for example, the operation data of the communication system, the operation state of the communication system, the network element feature attribute of the communication system, the engineering parameter information of the communication system, the environmental information (such as the wireless environmental information) of the communication system, the configuration parameter data of the communication system and/or the model data required for constructing the digital twin of the communication system.

The data of the communication system may also be considered as data of the physical network entity of the communication system.

In an embodiment, the data of the communication system includes one or more of the operation data, the operation state, the network element feature attribute, the engineering parameter information, the environmental information, the configuration parameter data, or the model data required for constructing the digital twin.

In an embodiment, the target data includes one or more of the data generated by constructing the digital twin of the communication system, or the data generated by the digital twin.

In this embodiment, the target data may also include the data generated by constructing the digital twin of the communication system and/or the data generated by the digital twin.

In an embodiment, the data generated by the digital twin includes operation condition data of the digital twin, where the operation condition data is transmitted by the digital twin to the first communication node periodically or in real time.

In this embodiment, the operation condition data of the digital twin may be construed as associated data for representing the operation condition of the digital twin.

The data generated by the digital twin may include the operation condition data of the digital twin. The operation condition data of the digital twin may be transmitted by the digital twin to the first communication node periodically (for example, the digital twin control platform may control the digital twin to report the corresponding operation condition data periodically) or in real time. This is not limited herein.

In an embodiment, the model library includes one or more of the data type model, the simulation type model, the intelligence type model, or the protocol stack model.

In this embodiment, the model library generated based on the target data may include the one or more models. For example, the model library may include, but is not limited to, the data type model, the simulation type model, the intelligence type model and/or the protocol stack model.

In an embodiment, the data type model includes the historical network data attribute set of the communication system and the current network data attribute set of the communication system.

In this embodiment, the data type model depends on data collection and may include the historical network data attribute set representing the communication system and the current network data attribute set representing the communication system to track a dynamic change in a network state. The data type model may include, but is not limited to, a model based on various calculation statistical indicators and key performance indicators (KPIs).

The data type model may be generated according to data such as a data type model used in the physical network entity and the operation state of the data type model.

In an embodiment, the simulation type model is the model that simulates the physical process of the network of the communication system and the function of the network of the communication system.

In this embodiment, the simulation type model may be construed as the model that simulates the physical process of the network of the communication system and the function of the network of the communication system. The simulation type model may include, but is not limited to, an algorithm model, a service model, a channel model and an environment model.

The simulation type model may be generated according to data such as operation data of the physical network entity and the physical performance of the physical network entity.

In an embodiment, the intelligence type model is the model constructed based on the target technology for the input and output of the data, where the target technology includes artificial intelligence technology.

In this embodiment, the target technology may be construed as the technology used for constructing the intelligence type model and may include, but is not limited to, the artificial intelligence technology, and the artificial intelligence technology may include the artificial intelligence technology based on machine learning or deep learning.

The intelligence type model may be construed as the model constructed based on the target technology for the input and output of the data. The intelligence type model includes, but is not limited to, an AI algorithm model, an AI scheduling model and an AI channel model.

The intelligence type model may be constructed according to the operation data of the physical network entity.

In an embodiment, the protocol stack model is the model of the protocol stack architecture of the communication system, and the protocol stack architecture is obtained according to the communication standard.

In this embodiment, the protocol stack model may be considered as the model of the protocol stack architecture of the communication system, and the protocol stack architecture is obtained according to the communication standard. The protocol stack model may include a model of the protocol stack architecture of a communication system based on LTE, NR, or 6G or a model of the protocol stack architecture of another communication system. Different communication systems may correspond to different protocol stack models.

In an embodiment, that the model required for constructing the digital twin of the communication system is acquired from the model library includes the following.

The model required for constructing the digital twin of the communication system is acquired from the model library through the digital twin control platform, where the model library is stored in the data platform.

In this embodiment, the model library generated based on the target data of the communication system may be stored in the data platform in the digital twin control platform. The first communication node may acquire, from the model library through the digital twin control platform, the model required for constructing the digital twin of the communication system.

In an embodiment, the models each include a model architecture and a model parameter.

In this embodiment, the models may each include the model architecture and the model parameter. The model architecture may be construed as a constituent framework structure of a model. The model parameter may be construed as a configuration parameter of a model.

For example, for a neural network type model, the model architecture may include the number of network layers, the number of hidden layers, or the number of convolutional layers; and the model parameter may include a weighted value, a convolution kernel parameter, or a bias.

In an embodiment, that the model required for constructing the digital twin of the communication system is acquired from the model library includes the following.

The protocol stack model, the simulation type model and the intelligence type model are acquired from the model library.

The simulation type model and the intelligence type model are applied to the protocol stack model.

The data type model is acquired.

In this embodiment, the process of acquiring, from the model library, the model required for constructing the digital twin of the communication system may be the following. Since the protocol stack model is the basic function implementation of the digital twin, has the most basic protocol stack function and is also the basic architecture of the digital twin, the protocol stack model may be first acquired as the basis. The simulation type model and the intelligence type model are then acquired and applied to the protocol stack model to maximize the approximation and reflection of the network performance of the physical network entity in the reality. The data type model may be finally acquired to perceive and acquire the operation condition of the digital twin.

It is to be noted that the protocol stack model, as the basis, is required to be first acquired, and the acquisition sequence of other models (such as the simulation type model, the intelligence type model and the data type model) may be determined according to the actual requirement. This is not limited herein.

In an embodiment, that the digital twin is constructed based on the model includes the following.

The model is transmitted to the second communication node, where the second communication node includes the digital twin.

In this embodiment, when the carrier of the digital twin is the second communication node, the first communication node may transmit the acquired model to the second communication node, and the second communication node constructs the digital twin based on the model.

In an embodiment, that the model is transmitted to the second communication node includes the following.

The protocol stack model is transmitted.

The simulation type model, the intelligence type model and the data type model are transmitted.

In this embodiment, when the model is transmitted to the second communication node, the protocol stack model as the basis is also first transmitted to the second communication node, and the simulation type model, the intelligence type model and the data type model are then transmitted.

In an embodiment, models may be first indicated, and parameters of the models are then transmitted. For example, n (such as 12) bits may be used for indicating the types of the models and the models under the corresponding types of the models. The first m such as two bits are used for indicating the types of the models. For example, 00 denotes the protocol stack model, 01 denotes the data type model, 10 denotes the simulation type model, and 11 denotes the intelligence type model. The last 10bit denotes the models under the corresponding types of the models. The value of m may be determined by the number of types of models included in the model library. The value of m and the value of n are not limited in this embodiment.

In an embodiment, the simulation type model and the intelligence type model in the models include a standard model and a non-standard model.

The model architecture of the standard model is fixed and the model parameter of the standard model is changeable.

The model architecture of the non-standard model and the model parameter of the non-standard model are changeable.

In this embodiment, the simulation type model and/or the intelligence type model may include the standard model and the non-standard model.

The standard model may be construed as a model that has a fixed model architecture and a changeable model parameter, for example, a linear model.

The non-standard model may be construed as a model that has a changeable model architecture and a changeable model parameter, for example, the neural network model whose network model architecture and network model parameter may change.

In an embodiment, in response to the standard model being transmitted to the second communication node for a first time, transmitted content of the standard model includes a model architecture and a model parameter that correspond to the standard model; and in response to the standard model being transmitted to the second communication node for a time other than the first time, the digital twin controls transmission of an updated model parameter according to an operation state.

In this embodiment, for the standard model, in the case where the first communication node transmits the standard model to the second communication node including the digital twin for the first time, the transmitted content of the standard content may include the model architecture and the model parameter that correspond to the standard model. In the case where the first communication node transmits the standard model to the second communication node including the digital twin for a time other than the first time, the digital twin may control the transmission of the updated model parameter according to the operation state. The operation state is not specifically limited herein. For example, the operation state may be the operation state of the digital twin or the operation state of the digital twin control platform.

For example, that the digital twin controls the transmission of the updated model parameter according to the operation state may be that the digital twin periodically checks and acquires the updated model parameter, thereby achieving the automatic updating, or that the digital twin control platform may only control delivery of the updated model parameter according to the operation state uploaded by the digital twin. The complexity of the system can be reduced by transmitting only the updated model parameter.

In an embodiment, in response to the non-standard model being transmitted to the second communication node for a first time, transmitted content of the non-standard model includes a model architecture and a model parameter that correspond to the non-standard model; and in response to the non-standard model being transmitted to the second communication node for a time other than the first time, transmitted content of the non-standard model includes the following incrementally or fully: the model architecture and the model parameter that correspond to the non-standard model.

In this embodiment, for the non-standard model, in the case where the first communication node transmits the non-standard model to the second communication node including the digital twin for the first time, the transmitted content may include the model architecture and the model parameter that correspond to the non-standard model. In the case where the first communication node transmits the non-standard model to the second communication node including the digital twin for a time other than the first time, the transmitted content may include the following incrementally or fully: the model architecture and the model parameter that correspond to the non-standard model. "Fully" may be considered as the entirety of corresponding content. For example, the full amount of a model parameter may be all model parameters of a corresponding model. "Incrementally" may be considered as updated content. For example, an incremental model parameter may be a model parameter updated this time, and a model parameter not updated this time is not transmitted.

The construction method is illustrated exemplarily below through different embodiments.

The present application provides a construction method for a digital twin of a communication system so that an accurate, efficient and modular digital twin can be constructed. The present application may be applied to communication systems and wireless communications that include 4G LTE, 5G NR and 6G wireless communication systems and may also be configured to construct digital twins for other communication systems.

FIG. 2 is a diagram illustrating the implementation of a construction method for a digital twin of a communication system according to an embodiment. As shown in FIG. 2, an implementation process of the construction method includes the following.

In S210, a data platform is used for storing all data generated by a physical network entity.

In S220, a model library is generated and stored in the data platform.

In S230, a digital twin control platform acquires a model from the data platform.

In S240, the digital twin control platform delivers the model to a digital twin.

In S250, the model of the digital twin is used.

The construction of the digital twin of the communication system involves the physical network entity, the digital twin control platform and the digital twin, and the digital twin control platform controls the digital twin so that the digital twin of the physical network entity can be obtained. To achieve the preceding object, as shown in FIG. 2, the diagram illustrating the implementation of the construction method for the digital twin in the present application mainly includes five steps. The specific solution is described below.

In the first step, the data platform is used for storing all the data generated by the physical network entity.

The data platform is used for storing all the data generated in the process of constructing the digital twin, where all the data includes all operation data and configuration parameter data that are generated by the physical network entity and model data (such as target data) required for constructing the digital twin.

In the second step, the model library is generated and stored in the data platform.

The model library is generated and stored in the data platform according to data of the physical network entity, such as operation data, an operation state, a network element feature attribute, engineering parameter information and a wireless environment. In addition, after the digital twin is constructed and operated, the model library may also be generated and stored in the data platform according to other data such as operation data generated by the digital twin (that is, data generated by the digital twin and data generated by constructing the digital twin of the communication system). The model library includes, but is not limited to, a data type model, a simulation type model, an intelligence type model and a protocol stack model. The data type model depends on data collection, may include a historical network data attribute set and a current network data attribute set and is configured to track a dynamic change in a network state. The data type model is generated and stored in the data platform according to a data type model used in the physical network entity and the operation state of the data type model. The simulation type model is a model that simulates a physical process of a network and a function of the network. The stimulation type model is generated and stored in the data platform according to the operation data of the physical network entity and the physical performance of the physical network entity. The intelligence type model is an intelligent model constructed based on AI intelligent techniques such as machine learning and deep learning for the input and output of data. The intelligence type model is constructed and stored in the data platform according to the operation data of the physical network entity. The protocol stack model is a model of the protocol stack architecture of the communication system, where the protocol stack architecture is obtained according to a communication standard; and the protocol stack model includes a model of the protocol stack architecture of LTE, NR, or 6G or a model of the protocol stack architecture of another communication system.

In the third step, the digital twin control platform acquires the model from the data platform.

The model acquired by the digital twin control platform from the model library includes a model architecture and a model parameter. The protocol stack model is first acquired. The protocol stack model is the basic function implementation of the digital twin, has the most basic protocol stack function and is also the basic architecture of the digital twin. The simulation type model and the intelligence type model are then acquired. The simulation type model includes, but is not limited to, an algorithm model, a service model, a channel model and an environment model. The intelligence type model includes, but is not limited to, an AI algorithm model, an AI scheduling model and an AI channel model. The two models (that is, the simulation type model and the intelligence type model) are applied to the protocol stack model to maximize the approximation and reflection of the network performance of the physical network entity in the reality. The data type model is finally acquired. The data type model includes, but is not limited to, various calculation statistical indicators and KPIs and may be configured to perceive and acquire the operation condition of the digital twin.

In the fourth step, the digital twin control platform delivers the model to the digital twin.

The digital twin control platform first delivers the protocol stack model to the digital twin and after controlling the digital twin to start, delivers the simulation type model, the intelligence type model and the data type model. There are multiple specific models under each type model. The digital twin control platform classifies and numbers the multiple models, and controls the delivery of the models and the reception of the model of the digital twin through communication and interaction with the digital twin.

For the data type model, the operation condition of the digital twin is required for perception in real time and is reported to the digital twin control platform by the digital twin in real time, or the digital twin control platform may also periodically control the digital twin to perform model reporting (that is, the operation condition data is transmitted by the digital twin to a first communication node periodically or in real time).

The simulation type model and the intelligence type model may be classified into a standard model and a non-standard model. The standard model has a fixed model architecture and a changeable model parameter, for example, a linear model. The non-standard model has a changeable model architecture and a changeable model parameter, for example, a neural network model whose network architecture and network parameter change. The model architecture and the model parameter are stored in the data platform. For the standard model, the digital twin control platform is required to only transmit the model architecture and the model parameter to the digital twin for the first time (that is, in response to the standard model being transmitted to a second communication node for the first time, transmitted content of the standard model includes a model architecture and a model parameter that correspond to the standard model). When the model parameter is updated, the digital twin control platform may only control the delivery of the updated model parameter according to the operation condition, thereby reducing the complexity of the system. Alternatively, the digital twin may also periodically check and acquire the updated model parameter, thereby achieving the automatic updating (that is, in response to the standard model being transmitted to the second communication node for a time other than the first time, the digital twin controls the transmission of the updated model parameter according to the operation state). For the non-standard model, the digital twin control platform is required to transmit the model architecture and the model parameter to the digital twin for the first time (that is, in response to the non-standard model being transmitted to the second communication node for the first time, transmitted content of the non-standard model includes a model architecture and a model parameter that correspond to the non-standard model). Afterward, according to a change in the model architecture and the model parameter, the model architecture and the model parameter are delivered incrementally or fully (that is, in response to the non-standard model being transmitted to the second communication node for a time other than the first time, transmitted content of the non-standard model includes the following incrementally or fully: the model architecture and the model parameter that correspond to the non-standard model).

In the fifth step, the model of the digital twin is used.

Models delivered by the digital twin control platform and received by the digital twin include the standard model and the non-standard model. For the standard model, after the model architecture of the standard model and the model parameter of the standard model are received for the first time, if the standard model is required for updating, the standard model corresponding to the digital twin is only required to be updated according to an updated model parameter delivered by the digital twin control platform. For the non-standard model, after the model architecture of the non-standard model and the model parameter of the non-standard model are received for the first time, if the non-standard model is required for updating, the non-standard model corresponding to the digital twin may be updated incrementally or fully according to the changed condition of the non-standard model in the data platform.

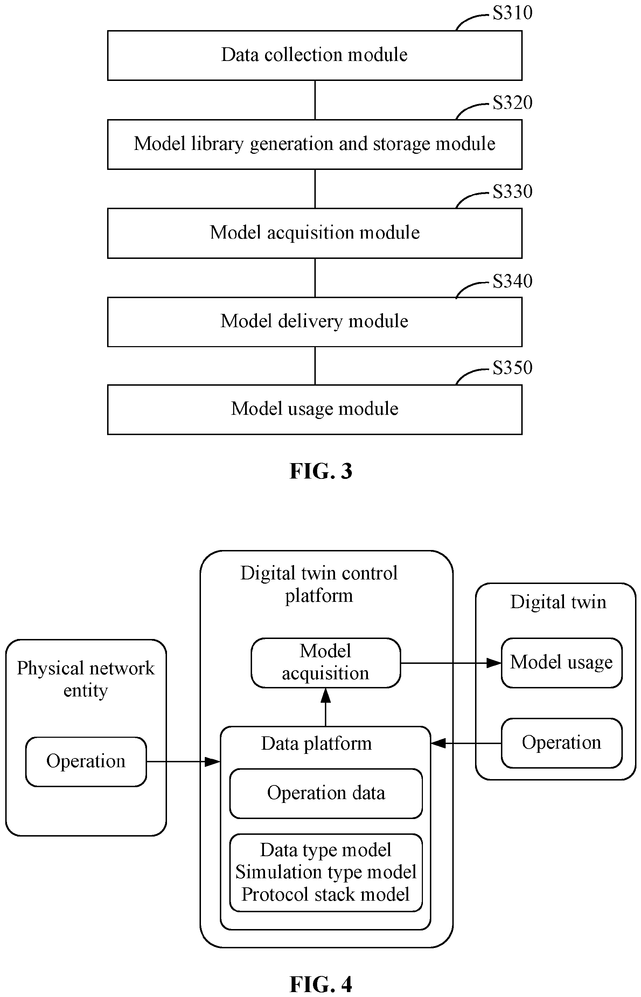

FIG. 3 is a diagram illustrating the implementation of a construction apparatus for a digital twin of a communication system according to an embodiment. As shown in FIG. 3, the construction apparatus includes a data collection module 310, a model library generation and storage module 320, a model acquisition module 330, a model delivery module 340 and a model usage module 350. The data collection module 310, the model library generation and storage module 320, the model acquisition module 330 and the model delivery module 340 are located in a digital twin control platform.

The data collection module 310 is configured to use a data platform to store all data generated by a physical network entity.

The model library generation and storage module 320 is configured to generate a model library and store the model library in the data platform.

The model acquisition module 330 is configured to acquire a model from the data platform by a digital twin control platform.

The model delivery module 340 is configured to deliver the model to a digital twin by the digital twin control platform.

The model usage module 350 is configured to use the model of the digital twin. It is to be noted that in the present application, in addition to the data platform, other data storage manner such as a data warehouse may also be used for storing the data and the model.

FIG. 4 is another diagram illustrating the implementation of a construction method for a digital twin of a communication system according to an embodiment. As shown in FIG. 4, a physical network entity (that is, a physical network entity of the communication system), a digital twin control platform and a digital twin are included. The digital twin control platform stores all data generated by the physical network entity (such as operation data) through a data platform. Based on the data stored in the data platform, the digital twin control platform generates a model library and stores the model library in the data platform, where the model library may include a data type model, a simulation type model and a protocol stack model. The digital twin control platform acquires a model from the data platform. The digital twin control platform delivers the model to the digital twin. The model of the digital twin is used, that is, the digital twin is constructed based on the model.

### Embodiment one

An embodiment of the present application provides a construction method for a digital twin of a communication system. The constructed digital twin may be an LTE radio access network (RAN).

The construction of the digital twin of the communication system involves the physical network entity, the digital twin control platform and the digital twin, and the digital twin control platform controls the digital twin so that the digital twin of the physical network entity can be obtained. As shown in FIG. 2, five steps are mainly included. The specific solution is described below.

In the first step, the data platform is used for storing all the data generated by the physical network entity.

The data platform is used for storing all the data generated in the process of constructing the digital twin, where all the data includes all operation data and configuration parameter data that are generated by the physical network entity and model data required for constructing the digital twin. After the digital twin is constructed and operated, operation data generated by the digital twin may also be stored in the data platform.

In the second step, the model library is generated and stored in the data platform.

The model library is generated and stored in the data platform according to data of the physical network entity, such as operation data, an operation state, a network element feature attribute, engineering parameter information and a wireless environment. The model library includes, but is not limited to, a data type model, a simulation type model, an intelligence type model and a protocol stack model. It is to be noted that after the digital twin is operated, the model library may also be generated and stored in the data platform according to the operation data generated by the digital twin.

The data type model depends on data collection, may include a historical network data attribute set and a current network data attribute set and is configured to track a dynamic change in a network state. The data type model is generated and stored in the data platform. The data type model includes a secondary node (SN) adding success rate, an SN changing success rate, a secondary gNodeB (SgNB) abnormity release rate, a Radio Resource Control (RRC) connection establishment success rate, a radio drop rate, a success rate of LTE switching to NR, an in-system switching success rate, the average number of RRC users, Packet Data Convergence Protocol (PDCP) layer data traffic, medium access control (MAC) layer data traffic, an uplink physical resource block (PRB) utilization rate and a downlink PRB utilization rate.

The simulation type model is a model that simulates a physical process of a network and a function of the network. The stimulation type model is generated and stored in the data platform according to the operation data of the physical network entity and the physical performance of the physical network entity. The simulation type model includes a channel model, an environment model and an antenna model. A model architecture such as a probability model, a linear model, a polynomial model, or a mixture of the preceding models and a model parameter such as a constant term or a polynomial coefficient are stored in the data platform.

The intelligence type model is an intelligent model constructed based on AI intelligent techniques such as machine learning and deep learning for the input and output of data. The intelligence type model is constructed and stored in the data platform according to the operation data of the physical network entity. The intelligence type model such as the architecture of a neural network model (such as the number of network layers and the number of hidden layers) and the model parameter (such as a weight of the neural network model and a bias of the neural network model) are stored in the data platform.

The protocol stack model is a model of the protocol stack architecture of the communication system, and the protocol stack architecture is obtained according to a communication standard. The model of the protocol stack architecture of LTE including modules such as a kernel network, a base station and a user equipment (UE) is stored in the data platform.

In the third step, the digital twin control platform acquires the model from the data platform.

The protocol stack model, the data type model, the simulation type model and the intelligence type model exist in the data platform. Multiple models exist under each type model. The digital twin control platform is required to acquire corresponding models from the model library. The models each include a model architecture and a model parameter. An LTE protocol stack model is first acquired. The simulation type model (such as the channel model, the environment model and the antenna model) and the intelligence type model (such as an AI algorithm model, an AI scheduling model and an AI channel model that are of the neural network type) are then acquired. The simulation type model and the intelligence type model may simultaneously exist for the same physical entity. The digital twin control platform chooses to acquire one of the two models or both of the two models simultaneously and applies the two models to the protocol stack model so that the approximation and reflection of the network performance of the physical network entity in the reality can be maximized. The generated data type model is finally acquired to perceive and acquire the operation condition of the digital twin.

In the fourth step, the digital twin control platform delivers the model to the digital twin.

After various models are acquired, the digital twin control platform delivers the various models to the digital twin. To improve the response speed and interaction capability of a digital twin process, communication and interaction are performed through efficient interfaces. 12 bits are used for indicating the types of the various models and the various models under the corresponding types of the various models. The first two bits are used for indicating the types of the various models. 00 denotes the protocol stack model, 01 denotes the data type model, 10 denotes the simulation type model, and 11 denotes the intelligence type model. The last 10 bits (that is, the last 10bit) denote the various models under the corresponding types of the various models.

2bit is used for denoting the four type models. 10bit is used for denoting corresponding models under each type model. The various models are first indicated, and parameters are then transmitted. For the simulation type model and the intelligence type model, the number of parameters is relatively large. For the neural network type model, the model architecture is the number of network layers, the number of hidden layers, or the number of convolutional layers, and the model parameter is a weighted value, a bias, a convolutional kernel parameter, or a bias. After the various models are indicated, the parameters such as the weighted value and the bias are transmitted and delivered to the digital twin.

The digital twin control platform first delivers the LTE protocol stack model to the digital twin and after controlling the digital twin to start, delivers the simulation type model, the intelligence type model and the data type model. For the data type model, the operation condition of the digital twin is required for perception in real time and is reported by the digital twin to the digital twin control platform in real time, 12 bits are used for indicating the types of the models and the models under the corresponding types of the models, and a model result is then reported. For a standard simulation type model and a standard intelligence type model, the digital twin control platform is required to only transmit model architectures and model parameters to the digital twin for the first time, after the model parameters are updated, the digital twin control platform may only control the delivery of the updated model parameters according to the operation condition, thereby reducing the complexity of the system, or the digital twin may also periodically check and acquire the updated model parameters, thereby achieving the automatic updating.

In the fifth step, the model of the digital twin is used.

The digital twin receives the model delivered by the digital twin control platform. For the standard model, after the model architecture of the standard model and the model parameter of the standard model are received for the first time, if the standard model is required for updating, the standard model corresponding to the digital twin is only required to be updated according to an updated model parameter delivered by the digital twin control platform.

### Embodiment two

An embodiment of the present application provides a construction method for a digital twin of a communication system. The constructed digital twin may be an NR RAN.

The construction of the digital twin of the communication system involves the physical network entity, the digital twin control platform and the digital twin, and the digital twin control platform controls the digital twin so that the digital twin of the physical network entity can be obtained. As shown in FIG. 2, five steps are mainly included. The specific solution is described below.

In the first step, the data platform is used for storing all the data generated by the physical network entity.

The data platform is used for storing all the data generated in the process of constructing the digital twin, where all the data includes all operation data and configuration parameter data that are generated by the physical network entity and model data required for constructing the digital twin.

In the second step, the model library is generated and stored in the data platform.

The model library is generated and stored in the data platform according to data of the physical network entity, such as operation data, an operation state, a network element feature attribute, engineering parameter information and a wireless environment. The model library includes, but is not limited to, a data type model, a simulation type model, an intelligence type model and a protocol stack model.

The data type model depends on data collection, may include a historical network data attribute set and a current network data attribute set and is configured to track a dynamic change in a network state. According to a data type model used in the physical network entity, part of the data type model is embedded into the protocol stack model, such as the number of lost segment data unit (SDU) packets of an uplink PDCP, the number of lost SDU packets of a downlink PDCP, the number of discarded SDU packets of the downlink PDCP, the total number of SDUs of the uplink PDCP, or the total number of SDUs of the downlink PDCP.

The simulation type model includes a ray tracing model, an electromagnetic wave model, a scheduling algorithm model and a service model. A model architecture such as a logarithmic model, an exponential model, a higher-order-term model, or a mixture of the preceding models and a model parameter such as an exponential power or another coefficient are stored in the data platform.

The intelligence type model includes a neural network model as well as a deep learning model, a tree model, a generalized linear model and an integrated model that are of various network structures. An integrated model architecture (such as a base model, the number of trees, the depth of a tree, an integrated manner, or the number of nodes) and a model parameter (such as the value of a node or a weight of the generalized linear model) are stored in the data platform.

The model of the protocol stack architecture of NR including modules such as a kernel network, a base station and a UE is stored in the data platform.

In the third step, the digital twin control platform acquires the model from the data platform.

An NR protocol stack model is acquired. The simulation type model and the intelligence type model are then acquired. The simulation type model includes the ray tracing model, the electromagnetic wave model, the scheduling algorithm model and the service model. The intelligence type model includes an algorithm model, a scheduling model and a channel model that are of the integrated model architecture. The part of the data type model embedded into the protocol stack model is finally started.

In the fourth step, the digital twin control platform delivers the model to the digital twin.

After various models are acquired, the digital twin control platform delivers the various models to the digital twin. To improve the response speed and interaction capability of a digital twin process, communication and interaction are performed through efficient interfaces. 12 bits are used for indicating the types of the various models and the various models under the corresponding types of the various models. The first two bits are used for indicating the types of the various models. 00 denotes the protocol stack model, 01 denotes the data type model, 10 denotes the simulation type model, and 11 denotes the intelligence type model. The last 10bit denotes the various models under the corresponding types of the various models.

2bit is used for denoting the four type models. 10bit is used for denoting corresponding models under each type model. The models are first indicated, and parameters are then transmitted. For the simulation type model and the intelligence type model, the number of parameters is relatively large. For the integrated model, the model architecture is the number of trees, the depth of the tree, the integrated manner, or the number of nodes, and the parameter such as the value of the node is transmitted and delivered to the digital twin.

The digital twin control platform first delivers the NR protocol stack model to the digital twin. After the digital twin is controlled to start, the digital twin periodically requests the digital twin control platform to update a model. Similarly, 2bit is used for indicating the model required for updating. The model is then delivered through a model delivery mechanism of the digital twin control platform. For the data type model, the operation condition of the digital twin is required for perception in real time, the digital twin control platform may periodically control the digital twin to report a model result, 12 bits are used for indicating the types of the models and the models under the corresponding types of the models, and the model result is then reported.

For a non-standard simulation type model and a non-standard intelligence type model, the digital twin control platform is required to transmit model architectures and model parameters to the digital twin for the first time. Afterward, according to a change in the model architectures and the model parameters, the model architectures and the model parameters are delivered incrementally or fully.

In the fifth step, the model of the digital twin is used.

For the non-standard model, after the model architecture of the non-standard model and the model parameter of the non-standard model are received for the first time, if the non-standard model is required for updating, the non-standard model corresponding to the digital twin may be updated incrementally or fully according to the changed condition of the non-standard model in the data platform.

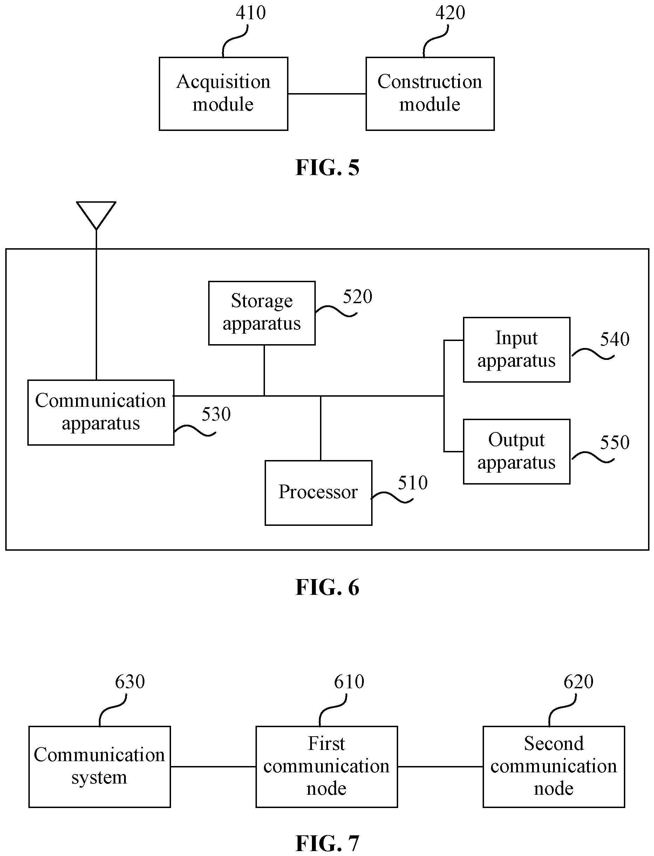

An embodiment of the present application further provides a construction apparatus. FIG. 5 is a diagram illustrating the structure of a construction apparatus according to an embodiment. As shown in FIG. 5, the construction apparatus may be configured in a first communication node. The construction apparatus includes an acquisition module 410 and a construction module 420.

The acquisition module 410 is configured to acquire, from a model library, a model required for constructing a digital twin of a communication system, where the model is generated based on target data of the communication system, and models for constructing multiple communication systems are stored in the model library.

The construction module 420 is configured to construct the digital twin based on the model.

In the construction apparatus provided in this embodiment, the models for constructing the multiple communication systems are stored in the model library, the model required for constructing the digital twin of the communication system may be acquired from the model library according to an actual requirement, and the digital twin is then constructed based on the model so that the generated digital twin can be applied to the multiple communication systems, thereby solving the problem that a communication node for constructing a digital twin of a communication system can only be dedicated to the construction of a digital twin of a certain communication system or a certain generation of communication system and improving the universality of the communication node.

In an embodiment, the construction apparatus further includes a generation module.

The generation module is configured to generate the model library based on the target data of the communication system.

In an embodiment, the construction apparatus further includes a data acquisition module and a data storage module.

The data acquisition module is configured to acquire the target data of the communication system.

The data storage module is configured to store the target data.

In an embodiment, the target data includes data of the communication system.

In an embodiment, the data of the communication system includes one or more of operation data, an operation state, a network element feature attribute, engineering parameter information, environmental information, configuration parameter data, or model data required for constructing the digital twin.

In an embodiment, the target data includes one or more of data generated by constructing the digital twin of the communication system or data generated by the digital twin.

In an embodiment, the data generated by the digital twin includes operation condition data of the digital twin, where the operation condition data is transmitted by the digital twin to the first communication node periodically or in real time.

In an embodiment, the model library includes one or more of a data type model, a simulation type model, an intelligence type model, or a protocol stack model.

In an embodiment, the data type model includes a historical network data attribute set of the communication system and a current network data attribute set of the communication system.

In an embodiment, the simulation type model is a model that simulates a physical process of a network of the communication system and a function of the network of the communication system.

In an embodiment, the intelligence type model is a model constructed based on the target technology for the input and output of data, where the target technology includes artificial intelligence technology.

In an embodiment, the protocol stack model is a model of the protocol stack architecture of the communication system, and the protocol stack architecture is obtained according to a communication standard.

In an embodiment, the acquisition module 410 includes a first acquisition unit.

The first acquisition unit is configured to acquire, from the model library through a digital twin control platform, the model required for constructing the digital twin of the communication system, where the model library is stored in a data platform.

In an embodiment, the models each include a model architecture and a model parameter.

In an embodiment, the acquisition module 410 includes a second acquisition unit, an application unit and a third acquisition unit.

The second acquisition unit is configured to acquire the protocol stack model, the simulation type model and the intelligence type model from the model library.

The application unit is configured to apply the simulation type model and the intelligence type model to the protocol stack model.

The third acquisition unit is configured to acquire the data type model.

In an embodiment, the construction module 420 includes a transmission unit.

The transmission unit is configured to transmit the model to a second communication node, where the second communication node includes the digital twin.

In an embodiment, that the model is transmitted to the second communication node includes the following.

The protocol stack model is transmitted.

The simulation type model, the intelligence type model and the data type model are transmitted.

In an embodiment, the simulation type model and the intelligence type model in the models include a standard model and a non-standard model.

A model architecture of the standard model is fixed and a model parameter of the standard model is changeable.

A model architecture of the non-standard model and a model parameter of the non-standard model are changeable.

In an embodiment, in response to the standard model being transmitted to the second communication node for a first time, transmitted content of the standard model includes a model architecture and a model parameter that correspond to the standard model; and in response to the standard model being transmitted to the second communication node for a time other than the first time, the digital twin controls the transmission of an updated model parameter according to an operation state.

In an embodiment, in response to the non-standard model being transmitted to the second communication node for a first time, transmitted content of the non-standard model includes a model architecture and a model parameter that correspond to the non-standard model; and in response to the non-standard model being transmitted to the second communication node for a time other than the first time, transmitted content of the non-standard model includes the following incrementally or fully: the model architecture and the model parameter that correspond to the non-standard model.

The construction apparatus provided in this embodiment belongs to the same inventive concept as the construction method provided in the preceding embodiments. For technical details not described in detail in this embodiment, reference may be made to any one of the preceding embodiments, and this embodiment has the same beneficial effects as the executed construction method.

An embodiment of the present application further provides a first communication node. FIG. 6 is a diagram illustrating the hardware structure of a first communication node according to an embodiment. As shown in FIG. 6, the first communication node provided in the present application includes a storage apparatus 520, a processor 510, and a computer program stored in the storage apparatus and executable by the processor. The processor 510 executes the computer program to perform the preceding construction method.

The first communication node may further include the storage apparatus 520. One or more processors 510 may be provided in the first communication node, and one processor 510 is shown as an example in FIG. 18. The storage apparatus 520 is configured to store one or more programs which, when executed by the one or more processors 510, cause the one or more processors 510 to perform the construction method in the embodiments of the present application.

The first communication node further includes a communication apparatus 530, an input apparatus 540 and an output apparatus 550.

The processor 510, the storage apparatus 520, the communication apparatus 530, the input apparatus 540 and the output apparatus 550 in the first communication node may be connected via a bus or other manners. The connection via the bus is shown as an example in FIG. 6.

The input apparatus 540 may be configured to receive input digital or character information and generate key signal input related to user settings of the first communication node and function control of the first communication node. The output apparatus 550 may include a display device such as a display screen.

The communication apparatus 530 may include a receiver and a sender. The communication apparatus 530 is configured to perform information transceiving communication under the control of the processor 510.

As a computer-readable storage medium, the storage apparatus 520 may be configured to store software programs, computer-executable programs and modules, such as program instructions/modules (such as the acquisition module 410 and the construction module 420 in the construction apparatus) corresponding to the construction method provided in the embodiments of the present application. The storage apparatus 520 may include a program storage region and a data storage region. The program storage region may store an operating system and an application program required by at least one function. The data storage region may store data created depending on use of the first communication node. In addition, the storage apparatus 520 may include a high-speed random-access memory and may further include a nonvolatile memory such as at least one disk memory, a flash memory or another nonvolatile solid-state memory. In some examples, the storage apparatus 520 may further include memories which are remotely disposed with respect to the processor 510. These remote memories may be connected to the first communication node via a network. Examples of the preceding network include, but are not limited to, the Internet, an intranet, a local area network, a mobile communication network and a combination thereof.

An embodiment of the present application further provides a storage medium. The storage medium stores a computer program which, when executed by a processor, causes the processor to perform the construction method provided in any one of the embodiments of the present application.

Optionally, the construction method is applied to a first communication node and includes: acquiring, from a model library, a model required for constructing a digital twin of a communication system, where the model is generated based on target data of the communication system, and models for constructing multiple communication systems are stored in the model library; and constructing the digital twin based on the model.

A computer storage medium in an embodiment of the present application may be one computer-readable medium or any combination of multiple computer-readable media. The computer-readable medium may be a computer-readable signal medium or a computer-readable storage medium. For example, the computer-readable storage medium may be, but is not limited to, an electrical, magnetic, optical, electromagnetic, infrared, or semiconductor system, apparatus, or device, or any combination thereof. More specific examples of the computer-readable storage medium include (non-exhaustive list): an electrical connection having one or more wires, a portable computer magnetic disk, a hard disk, a random-access memory (RAM), a read-only memory (ROM), an erasable programmable read-only memory (EPROM), a flash memory, an optical fiber, a portable compact disc ROM (CD-ROM), an optical memory, a magnetic memory, or any suitable combination thereof. The computer-readable storage medium may be any tangible medium including or storing a program. The program may be used by or used in conjunction with an instruction execution system, apparatus, or device.

The computer-readable signal medium may include a data signal propagated in a baseband or as part of a carrier. The data signal carries computer-readable program codes. The data signal propagated in this manner may be in multiple forms, including, but not limited to, an electromagnetic signal, an optical signal, or any suitable combination thereof. The computer-readable signal medium may also be any computer-readable medium other than the computer-readable storage medium. The computer-readable medium may send, propagate, or transmit a program used by or used in conjunction with an instruction execution system, apparatus, or device.

The program codes included in the computer-readable medium may be transmitted in any suitable medium including, but not limited to, a wireless medium, a wire, an optical cable, radio frequency (RF), or any suitable combination thereof.

Computer program codes for performing the operations of the present application may be written in one or more programming languages or a combination thereof. The programming languages include object-oriented programming languages such as Java, Smalltalk, and C++ and may further include conventional procedural programming languages such as "C" or similar programming languages. The program codes may be executed entirely on a user computer, executed partly on a user computer, executed as a stand-alone software package, executed partly on a user computer and partly on a remote computer, or executed entirely on a remote computer or a server. In the case where the remote computer is involved, the remote computer may be connected to the user computer through any type of network including a local area network (LAN) or a wide area network (WAN) or may be connected to an external computer (for example, via the Internet provided by an Internet service provider).

An embodiment of the present application further provides a construction system. FIG. 7 is a diagram illustrating the structure of a construction system according to an embodiment. As shown in FIG. 7, the construction system provided in the present application includes the first communication node 610 provided in the embodiment of the present application, a second communication node 620 and a communication system 630. The second communication node 620 includes a digital twin of the communication system 630.

A communication connection is established between the first communication node 610, the second communication node 620 and the communication system 630. The first communication node 610 may include a digital twin control platform. The second communication node 620 may include the digital twin of the communication system 630. The communication system 630 may be considered as a physical network entity of the communication system.

The first communication node 610 stores all data (such as operation data) generated by the physical network entity of the communication system 630 through a data platform. Based on the data stored in the data platform, the first communication node 610 generates a model library and stores the model library in the data platform, where the model library may include a data type model, a simulation type model and a protocol stack model. The first communication node 610 acquires, from the model library in the data platform, a model required for constructing the digital twin of the communication system 630. The first communication node 610 delivers the model to a second communication node 630. The model of the second communication node 630 is used, that is, the second communication node 630 constructs the digital twin based on the model.

The construction system provided in this embodiment belongs to the same inventive concept as the construction method provided in the preceding embodiments. For technical details not described in detail in this embodiment, reference may be made to any one of the preceding embodiments, and this embodiment has the same beneficial effects as the executed construction method.

The preceding are example embodiments of the present application and are not intended to limit the scope of the present application.

It is to be understood by those skilled in the art that the term "user equipment" encompasses any suitable type of radio user device such as a mobile phone, a portable data processing apparatus, a portable web browser, or a vehicle-mounted mobile station.

Generally speaking, embodiments of the present application may be implemented in hardware or special-purpose circuits, software, logic, or any combination thereof. For example, some aspects may be implemented in hardware while other aspects may be implemented in firmware or software executable by a controller, a microprocessor, or another computing apparatus, though the present application is not limited thereto.

Embodiments of the present application may be implemented through the execution of computer program instructions by a data processor of a mobile apparatus, for example, implemented in a processor entity, by hardware, or by a combination of software and hardware. The computer program instructions may be assembly instructions, instruction set architecture (ISA) instructions, machine instructions, machine-related instructions, microcodes, firmware instructions, status setting data, or source or object codes written in any combination of one or more programming languages.

A block diagram of any logic flow among the drawings of the present application may represent program steps, may represent interconnected logic circuits, modules and functions, or may represent a combination of program steps and logic circuits, modules and functions. Computer programs may be stored in a memory. The memory may be of any type suitable for a local technical environment and may be implemented using any suitable data storage technology, such as, but not limited to, a read-only memory (ROM), a random-access memory (RAM) and an optical memory device and system (a digital video disc (DVD) or a compact disc (CD)). The computer-readable media may include non-transitory storage media. The data processor may be of any type suitable for the local technical environment, such as, but not limited to, a general-purpose computer, a special-purpose computer, a microprocessor, a digital signal processor (DSP), an application-specific integrated circuit (ASIC), a field-programmable gate array (FPGA) and a processor based on a multi-core processor architecture.

The detailed description of example embodiments of the present application is provided above through exemplary and non-restrictive examples. However, considering the drawings and the claims, various modifications and adjustments to the preceding embodiments are apparent to those skilled in the art and do not deviate from the scope of the present application. Accordingly, the proper scope of the present application is determined according to the claims.

## Claims

1. A construction method, the method being applied to a first communication node and comprising:
acquiring, from a model library, a model required for constructing a digital twin of a communication system, wherein the model is generated based on target data of the communication system, and models for constructing a plurality of communication systems are stored in the model library; and
constructing the digital twin based on the model.

2. The construction method of claim 1, further comprising:
generating the model library based on the target data of the communication system.

3. The construction method of claim 1, further comprising:
acquiring the target data of the communication system; and
storing the target data.

4. The construction method of claim 1, wherein the target data comprises:
data of the communication system.

5. The construction method of claim 4, wherein the data of the communication system comprises one or more of:
operation data, an operation state, a network element feature attribute, engineering parameter information, environmental information, configuration parameter data, or model data required for constructing the digital twin.

6. The construction method of claim 1, wherein the target data comprises one or more of:
data generated by constructing the digital twin of the communication system; or
data generated by the digital twin.

7. The construction method of claim 6, wherein the data generated by the digital twin comprises:
operation condition data of the digital twin, wherein the operation condition data is transmitted by the digital twin to the first communication node periodically or in real time.

8. The construction method of claim 1, wherein the model library comprises one or more of:
a data type model;
a simulation type model;
an intelligence type model; or
a protocol stack model.

9. The construction method of claim 8, wherein the data type model comprises a historical network data attribute set of the communication system and a current network data attribute set of the communication system.

10. The construction method of claim 8, wherein the simulation type model is a model that simulates a physical process of a network of the communication system and a function of the network of the communication system.

11. The construction method of claim 8, wherein the intelligence type model is a model constructed based on a target technology for input and output of data, wherein the target technology comprises an artificial intelligence technology.

12. The construction method of claim 8, wherein the protocol stack model is a model of a protocol stack architecture of the communication system, and the protocol stack architecture is obtained according to a communication standard.

13. The construction method of claim 1, wherein acquiring, from the model library, the model required for constructing the digital twin of the communication system comprises:
acquiring, from the model library through a digital twin control platform, the model required for constructing the digital twin of the communication system, wherein the model library is stored in a data platform.

14. The construction method of claim 1, wherein the models each comprise a model architecture and a model parameter.

15. The construction method of claim 1, wherein acquiring, from the model library, the model required for constructing the digital twin of the communication system comprises:
acquiring a protocol stack model, a simulation type model and an intelligence type model from the model library;
applying the simulation type model and the intelligence type model to the protocol stack model; and
acquiring a data type model.

16. The construction method of claim 1, wherein constructing the digital twin based on the model comprises:
transmitting the model to a second communication node, wherein the second communication node comprises the digital twin.

17. The construction method of claim 16, wherein transmitting the model to the second communication node comprises:
transmitting a protocol stack model; and
transmitting a simulation type model, an intelligence type model and a data type model.

18. The construction method of claim 1, wherein a simulation type model and an intelligence type model in the models comprise a standard model and a non-standard model,
wherein a model architecture of the standard model is fixed and a model parameter of the standard model is changeable; and
wherein a model architecture of the non-standard model and a model parameter of the non-standard model are changeable.

19. The construction method of claim 18, wherein
in response to the standard model being transmitted to a second communication node for a first time, transmitted content of the standard model comprises a model architecture and a model parameter that correspond to the standard model; and
in response to the standard model being transmitted to the second communication node for a time other than the first time, the digital twin controls transmission of an updated model parameter according to an operation state.

20. The method of claim 18, wherein
in response to the non-standard model being transmitted to a second communication node for a first time, transmitted content of the non-standard model comprises a model architecture and a model parameter that correspond to the non-standard model; and
in response to the non-standard model being transmitted to the second communication node for a time other than the first time, transmitted content of the non-standard model comprises the following incrementally or fully: the model architecture and the model parameter that correspond to the non-standard model.

21. A first communication node, comprising:
one or more processors; and
a storage apparatus in which one or more programs are stored,
wherein the one or more programs, when executed by the one or more processors, cause the one or more processors to perform the method of any one of claims 1 to 20.

22. A storage medium storing a computer program which, when executed by a processor, causes the processor to perform the method of any one of claims 1 to 20.

23. A construction system, comprising the first communication node of claim 21, a second communication node and a communication system, wherein a digital twin of the communication system is comprised in the second communication node.
